# EUROPEAN PATENT APPLICATION

(11) **EP 4 694 624 A1**
(43) Date of publication of application: **11.02.2026**
(21) Application number: 25186107.6
(22) Date of filing: 30.06.2025
(51) Int. Cl.: H10D 88/00, H10D 30/67, H01L 21/768, H01L 23/485, H01L 23/528

(54) **OFFSET FRONTSIDE AND BACKSIDE INTERCONNECT TRACKS OF A STANDARD UNIT CELL**

(30) Priority: 05.08.2024 US 202418794230
(71) Applicant: INTEL Corporation, Santa Clara, CA 95054 (US)
(72) Inventor: Li, Xia, San Diego CA 92130 (US); Aprameyan, Prashanth, San Jose CA 95135 (US); Liu, Ming-Xu, Maricopa AZ 85138 (US)
(74) Representative: Samson & Partner Patentanwälte mbB

(57) **Abstract**

Techniques are provided herein to form semiconductor devices within a standard unit cell having topside metal tracks that are offset from backside metal tracks. Stacked transistors are provided such that a source or drain region of one device is located vertically over the source or drain region of the other device. Both frontside and backside contacts may be formed to contact either top or bottom surfaces of the corresponding source or drain regions. Topside metal tracks are used to provide signal and power to various transistor elements of the top semiconductor device while backside metal tracks are used to provide signal and power to various transistor elements of the bottom semiconductor device. The topside tracks are offset from the backside tracks such that one topside track is aligned along one boundary of a standard unit cell and one backside track is aligned along the opposite standard unit cell boundary.

## Description

### BACKGROUND

As integrated circuits continue to scale downward in size, a number of challenges arise. For instance, reducing the size of memory and logic cells or otherwise increasing device density is becoming increasingly more difficult. One possible solution to increase device density is to stack transistor devices in a vertical direction. As a result, providing sufficient connections to all transistor elements becomes difficult. There are many non-trivial challenges involved with the fabrication of such stacked devices and the fabrication of contacts to the associated device structures.

### BRIEF DESCRIPTION OF THE DRAWINGS

Figures 1A and 1B are cross-sectional views of an example integrated circuit having stacked semiconductor devices with frontside interconnect tracks offset from backside interconnect tracks, in accordance with an embodiment of the present disclosure.
Figure 1C includes top-down views of a frontside layout for a first semiconductor device and a backside layout for a second semiconductor device illustrating the offset topside and backside interconnects, in accordance with an embodiment of the present disclosure.
Figures 2A and 2B are cross-sectional views that illustrate one stage in an example process for forming an integrated circuit having stacked semiconductor devices with offset frontside and backside interconnect tracks, in accordance with an embodiment of the present disclosure.
Figures 3A and 3B are cross-sectional views that illustrate another stage in the example process for forming an integrated circuit having stacked semiconductor devices with offset frontside and backside interconnect tracks, in accordance with an embodiment of the present disclosure.
Figures 4A and 4B are cross-sectional views that illustrate another stage in the example process for forming an integrated circuit having stacked semiconductor devices with offset frontside and backside interconnect tracks, in accordance with an embodiment of the present disclosure.
Figures 5A and 5B are cross-sectional views that illustrate another stage in the example process for forming an integrated circuit having stacked semiconductor devices with offset frontside and backside interconnect tracks, in accordance with an embodiment of the present disclosure.
Figures 6A and 6B are cross-sectional views that illustrate another stage in the example process for forming an integrated circuit having stacked semiconductor devices with offset frontside and backside interconnect tracks, in accordance with an embodiment of the present disclosure.
Figures 7A and 7B are cross-sectional views that illustrate another stage in the example process for forming an integrated circuit having stacked semiconductor devices with offset frontside and backside interconnect tracks, in accordance with an embodiment of the present disclosure.
Figures 8A and 8B are cross-sectional views that illustrate another stage in the example process for forming an integrated circuit having stacked semiconductor devices with offset frontside and backside interconnect tracks, in accordance with an embodiment of the present disclosure.
Figures 9A and 9B are cross-sectional views that illustrate another stage in the example process for forming an integrated circuit having stacked semiconductor devices with offset frontside and backside interconnect tracks, in accordance with an embodiment of the present disclosure.
Figures 10A and 10B are cross-sectional views that illustrate another stage in the example process for forming an integrated circuit having stacked semiconductor devices with offset frontside and backside interconnect tracks, in accordance with an embodiment of the present disclosure.
Figures 11A and 11B are cross-sectional views that illustrate another stage in the example process for forming an integrated circuit having stacked semiconductor devices with offset frontside and backside interconnect tracks, in accordance with an embodiment of the present disclosure.
Figures 12A and 12B are cross-sectional views that illustrate another stage in the example process for forming an integrated circuit having stacked semiconductor devices with offset frontside and backside interconnect tracks, in accordance with an embodiment of the present disclosure.
Figures 13A and 13B are cross-sectional views that illustrate another stage in the example process for forming an integrated circuit having stacked semiconductor devices with offset frontside and backside interconnect tracks, in accordance with an embodiment of the present disclosure.
Figures 14A and 14B are cross-sectional views that illustrate another stage in the example process for forming an integrated circuit having stacked semiconductor devices with offset frontside and backside interconnect tracks, in accordance with an embodiment of the present disclosure.
Figures 15A and 15B are cross-sectional views that illustrate another stage in the example process for forming an integrated circuit having stacked semiconductor devices with offset frontside and backside interconnect tracks, in accordance with an embodiment of the present disclosure.
Figure 16 illustrates a cross-section view of a chip package containing one or more semiconductor dies, in accordance with some embodiments of the present disclosure.
Figure 17 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices within a standard unit cell having topside metal tracks that are offset from backside metal tracks. The techniques can be used in any number of transistor technologies, but are particularly useful in a vertically stacked gate-all-around (GAA) (e.g., nanoribbon) transistor configuration or forksheet transistor configuration. In one example, two different semiconductor devices of a given memory or logic cell such as a synchronous random-access memory (SRAM) cell, or a complementary metal oxide semiconductor (CMOS) cell, include a p-channel device and an n-channel device. The n-channel device and the p-channel device may be, for example, GAA transistors each having any number of nanoribbons extending in the same direction, wherein the n-channel device is located vertically above the p-channel device (or vice versa). Source or drain regions are adjacent to both ends of the n-channel device and the p-channel device, such that a source or drain region of one device is located vertically over the source or drain region of the other device. Both frontside and backside contacts may be formed to contact either top or bottom surfaces of the corresponding source or drain regions. One or more of the topside contacts may be formed deep enough to contact surfaces of two different source or drain regions that are stacked over one another. Topside metal tracks are used to provide signal and/or power to various transistor elements of the top semiconductor device while backside metal tracks are used to provide signal and/or power to various transistor elements of the bottom semiconductor device. The topside tracks may be offset from the backside tracks such that one of the topside tracks is aligned along one boundary of a standard unit cell and one of the backside tracks is aligned along the opposite boundary of the standard unit cell. Numerous variations and embodiments will be apparent in light of this disclosure.

### General Overview

As previously noted above, there remain a number of non-trivial challenges with respect to designing stacked semiconductor devices. In the case of stacked nanoribbon transistors, for example, providing signal and power connections to all transistor elements within the footprint of a standard unit cell is challenging. The boundaries of a standard unit cell define the layout for a single combinatorial field-effect-transistor (CFET) architecture (e.g., one n-channel transistor and one p-channel transistor). In some examples, the CFET architecture in the standard unit cell provides an inverter circuit. The standard unit cell may then be repeated across a larger layout of the integrated circuit. Topside and backside interconnect tracks (e.g., frontside and backside M0 tracks) may be used to provide signal and power to the various transistor elements in a given standard unit cell.

In accordance with an embodiment of the present disclosure, techniques are provided herein to form topside interconnect tracks and backside interconnect tracks across a CFET standard unit cell where the topside interconnect tracks are offset from the backside interconnect tracks. According to some embodiments, an N number of interconnect tracks are used on both the topside and backside of the standard unit cell to provide power and/or signal connections to various transistor elements. According to some examples, N may be 3, 4, or 5 depending on the application. The interconnect tracks define parallel conductive lines that are separated from one another by a given pitch. According to some embodiments, a plurality of topside interconnect tracks extend parallel to one another along a first direction (e.g., along an X-axis), and a plurality of backside interconnect tracks extend parallel to one another along the first direction. According to some such embodiments, the plurality of topside interconnect tracks are offset from the plurality of backside interconnect tracks along a second direction (e.g., along a Y-axis) substantially orthogonal to the first direction (and different from the vertical direction). Due to the offset, one of the plurality of topside interconnect tracks may be aligned along a first boundary of the standard unit cell, and one of the plurality of backside interconnect tracks may be aligned along a second boundary of the unit cell opposite from the first boundary. The techniques can be applied to any number of channel configurations, such as stacked planar transistors, finFETs, GAA transistors, and forksheet transistors.

According to an embodiment, an integrated circuit includes a first semiconductor region extending from a first source or drain region to a second source or drain region in a first direction, a second semiconductor region extending from a third source or drain region to a fourth source or drain region in the first direction, and a gate structure extending over the first semiconductor region and the second semiconductor region in a second direction substantially orthogonal to the first direction. The first source or drain region is spaced from the third source or drain region in a third direction substantially orthogonal to the first and second directions, and the second source or drain region is spaced from the fourth source or drain region in the third direction. The integrated circuit also includes a first plurality of conductive layers above the first semiconductor region and extending lengthwise along the first direction and a second plurality of conductive layers below the second semiconductor region and extending lengthwise along the first direction. The first plurality of conductive layers are separated from one another along the second direction by a first pitch, and the second plurality of conductive layers are separated from one another along the second direction by a second pitch. The first plurality of conductive layers are offset from the second plurality of conductive layers along the second direction by between 1 nm and 5 nm.

According to another embodiment, an integrated circuit includes a standard unit cell having a first semiconductor device and a second semiconductor device. The standard unit cell includes a layout that is repeated across at least a portion of the integrated circuit. The first semiconductor device includes a first semiconductor region extending from a first source or drain region to a second source or drain region in a first direction, and a first portion of a gate structure extending over the first semiconductor region in a second direction substantially orthogonal to the first direction. The second semiconductor device includes a second semiconductor region extending from a third source or drain region to a fourth source or drain region in the first direction, and a second portion of the gate structure extending over the second semiconductor region in the second direction. The first source or drain region is spaced from the third source or drain region in a third direction substantially orthogonal to the first and second directions, and the second source or drain region is spaced from the fourth source or drain region in the third direction. The integrated circuit also includes a first plurality of parallel conductive layers above the first semiconductor device, and a second plurality of parallel conductive layers below the second semiconductor device. The first plurality of conductive layers are offset from the second plurality of conductive layers along the first direction or along the second direction. A first conductive layer of the first plurality of conductive layers is aligned along a first boundary of the standard unit cell, and a second conductive layer of the second plurality of conductive layers is aligned along a second boundary of the standard unit cell. The second boundary is parallel to the first boundary.

According to another embodiment, an electronic device includes a chip package having one or more dies. At least one of the one or more dies includes a first semiconductor device comprising a first semiconductor region extending from a first source or drain region to a second source or drain region in a first direction and a first portion of a gate structure extending over the first semiconductor region in a second direction substantially orthogonal to the first direction, and a second semiconductor device comprising a second semiconductor region extending from a third source or drain region to a fourth source or drain region in the first direction and a second portion of the gate structure extending over the second semiconductor region in the second direction. The first source or drain region is spaced from the third source or drain region in a third direction substantially orthogonal to the first and second directions, and the second source or drain region is spaced from the fourth source or drain region in the third direction. The at least one of the one or more dies further includes a first plurality of conductive layers above the first semiconductor region and extending lengthwise along the first direction and a second plurality of conductive layers below the second semiconductor region and extending lengthwise along the first direction. The first plurality of conductive layers are separated from one another along the second direction by a first pitch, and the second plurality of conductive layers are separated from one another along the second direction by a second pitch. The first plurality of conductive layers are offset from the second plurality of conductive layers along the second direction by between 1 nm and 5 nm.

The techniques are especially suited for use with gate-all-around transistors such as nanowire and nanoribbon transistors, but may also be applicable in some instances to finFET devices (e.g., stacked finFET structures). The source and drain regions can be, for example, doped portions of a given fin, nanoribbon, or substrate, or epitaxial regions that are deposited during an etch-and-replace source/drain forming process. The dopant-type in the source and drain regions will depend on the polarity of the corresponding transistor. The gate electrode can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate a particular arrangement of frontside and backside interconnect tracks where the frontside tracks are offset from the backside tracks.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

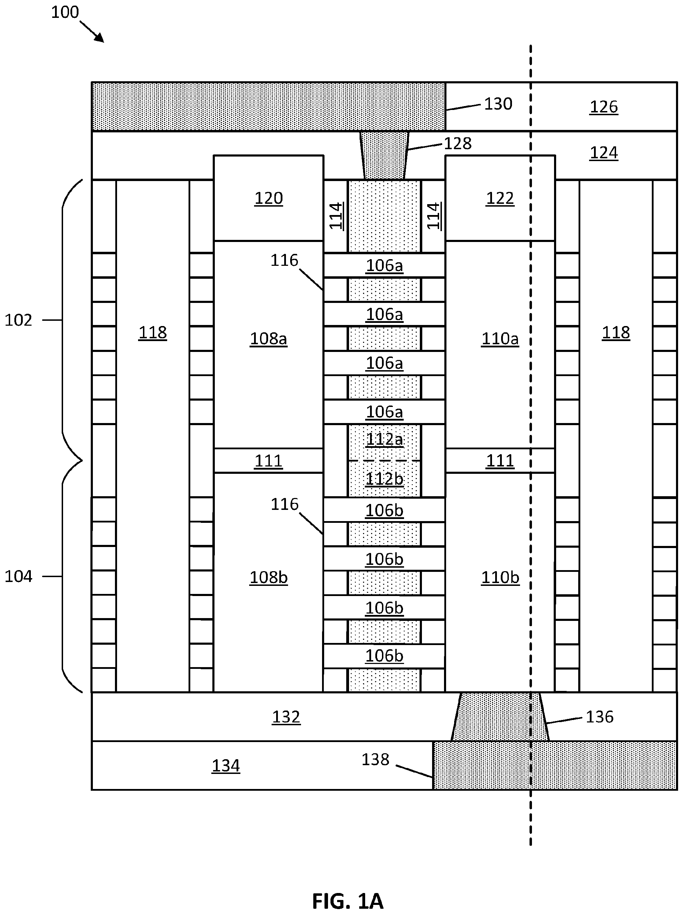

Figure 1A is a cross sectional view of a portion of an integrated circuit 100 that includes a first semiconductor device 102 and a second semiconductor device 104, where first semiconductor device 102 is stacked vertically over second semiconductor device 104, according to an embodiment of the present disclosure. The cross-section view is taken lengthwise (perpendicular to gate structure) across first semiconductor device 102 and second semiconductor device 104 in a first direction. The gate structure runs into and out of the page along a second direction while the devices are vertically stacked over one another in a third direction substantially orthogonal to the first and second directions. Each of semiconductor devices 102 and 104 may be gate-all-around (GAA) or forksheet transistors, although other transistor topologies and types could also benefit from the techniques provided herein. For example, the illustrated embodiments herein depict a ribbonized channel region (e.g., nanowires, nanoribbons, or nanosheets), but in other examples the channel is a fin-shaped body of semiconductor material to provide stacked finFETs. Semiconductor devices 102 and 104 represent a portion of integrated circuit 100 that may contain any number of similar semiconductor devices. The description of such structures may apply equally to the corresponding structures of other stacked semiconductor devices in integrated circuit 100.

The one or more semiconductor regions of the devices may be formed from a fin of alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. The alternating layers can be blanket deposited and then etched into fins or deposited into fin-shaped trenches, in some examples. In other examples, the alternating layers may instead be a single layer or body of semiconductor material suitable for forming finFETs (e.g., double-gate or tri-gate transistors).

First semiconductor device 102 includes one or more semiconductor regions (also called channel regions), such as one or more nanoribbons 106a extending between an epitaxial first source or drain region 108a and an epitaxial second source or drain region 110a in the first direction. Similarly, second semiconductor device 104 includes one or more semiconductor nanoribbons 106b extending between an epitaxial third source or drain region 108b and an epitaxial fourth source or drain region 110b in the first direction. A first gate structure 112a extends over nanoribbons 106a of first semiconductor device 102 in a second direction (e.g., into and out of the page) to form the transistor gate of first semiconductor device 102 and second gate structure 112b extends over nanoribbons 106b of second semiconductor device 104 in the second direction to form the transistor gate of second semiconductor device 104. Note that first gate structure 112a and second gate structure 112b may be considered different portions of a single gate structure. According to some embodiments, first source or drain region 108a is separated in the third direction from third source or drain region 108b by a dielectric layer 111 and, similarly, second source or drain region 110a is separated in the third direction from fourth source or drain region 110b by another dielectric layer 111. Dielectric layer 111 may include any suitable dielectric material, such as silicon dioxide, silicon nitride, or silicon oxynitride.

Any of source or drain regions 108a/108b/110a/110b may act as either a source region or a drain region, depending on the application and dopant profile. Any semiconductor materials suitable for source and drain regions can be used (e.g., group IV and group III-V semiconductor materials) for any of the illustrated source or drains regions. In any such cases, the composition and doping of the source or drain regions may be the same or different, depending on the polarity of the transistors. In an example, first semiconductor device 102 may be an n-channel device having a high concentration of n-type dopants in the associated source or drain regions 108a/110a, and second semiconductor device 104 may be a p-channel device having a high concentration of p-type dopants in the associated source or drain regions 108b/110b. Example p-type dopants include boron and example n-type dopants include phosphorous or arsenic. Any number of source and drain configurations and materials can be used.

The gate structures 112a/112b may each include a gate electrode that is made up of a conductive fill and one or more metal workfunction layers, according to some embodiments. The gate structures 112a/112b also include a gate dielectric that may represent any number of dielectric layers. The conductive fill may include any sufficiently conductive material such as a metal, metal alloy, or doped polysilicon. In some examples, the conductive fill includes tungsten (W), although other metals or conductive materials may be used, such as aluminum (Al), molybdenum (Mo), ruthenium (Ru), cobalt (Co), titanium (Ti), tantalum (Ta), or doped polysilicon. In some embodiments, first semiconductor device 102 is an n-channel device having first gate structure 112a with one or more workfunction layers of tungsten. Other metal workfunction layers of n-channel devices can include tantalum nitride (TaN). In some embodiments, second semiconductor device 104 is a p-channel device having second gate structure 112b with one or more workfunction layers of tantalum nitride (TaN) and/or titanium nitride (TiN). As noted above, first gate structure 112a and second gate structure 112b may be conductively couped together within the same gate trench. For example, first gate structure 112a and second gate structure 112b may share the same conductive fill.

The gate dielectric of each gate structure 112a/112b may include any suitable gate dielectric material(s). In some embodiments, the gate dielectric includes a layer of native oxide material (e.g., silicon dioxide germanium dioxide, or SiGe oxide) on nanoribbons 106a/106b, and a layer of high-k dielectric material (e.g., hafnium oxide or aluminum oxide) on the native oxide. According to some embodiments, spacer structures 114 and inner spacers 116 are present along the sidewalls of gate structures 112a/112b. Spacer structures 114 and inner spacers 116 may be any suitable dielectric material, such as silicon nitride, and provide separation between a given gate structure 112a/112b and the adjacent source or drain regions. Inner spacers 116 may separate adjacent nanoribbons 106a/106b from one another along the third direction (e.g., the Z-direction).

According to some embodiments, one or more isolation structures 118 may be formed adjacent to the devices that cut across one or more fins to isolate devices on either side of the isolation structure. Isolation structures 118 may include one or more dielectric materials that extend in the second direction within a gate trench to cut through any number of fins present within the gate trench. In the illustrated example, isolation structures 118 extend along the second direction on either side of first semiconductor device 102 and second semiconductor device 104 to isolate such devices from any other devices formed along the first direction. Isolation structures 118 may include any suitable dielectric material, such as silicon nitride or any other oxide-based dielectric material. According to some embodiments, isolation structures 118 extend in the third direction along at least an entire height of the adjacent source or drain regions. A top surface of isolation structures 118 may be substantially coplanar with a top surface of spacer structures 114. Isolation structures 118 may not be needed in situations where adjacent devices along the first direction are intended to share a given source or drain region (or where dummy transistors are employed).

According to some embodiments, a first topside contact 120 may be used within the source/drain trench over first source or drain region 108a and a second topside contact 122 may be used within the source/drain trench over second source or drain region 110a. Topside contacts 120 and 122 may be any suitable conductive material, such as tungsten, molybdenum, ruthenium, or cobalt, to name a few examples.

According to some embodiments, a first topside dielectric layer 124 and a second topside dielectric layer 126 on first topside dielectric layer 124 are provided above first semiconductor device 102. Each of topside dielectric layers 124/126 may include any suitable dielectric material, such as silicon dioxide, and may be part of a multi-layer interconnect region. In some embodiments, a topside via 128 is formed through first topside dielectric layer 124 to make contact with first gate structure 112a, and a topside conductive layer 130 is formed through second topside dielectric layer 126 to make contact with topside via 128. Topside conductive layer 130 may be one conductive layer of a plurality of parallel conductive layers in the same plane as second topside dielectric layer 126.

According to some embodiments, a first backside dielectric layer 132 and a second backside dielectric layer 134 below first backside dielectric layer 132 are provided beneath second semiconductor device 104. Each of backside dielectric layers 132/134 may include any suitable dielectric material, such as silicon dioxide, and may be part of a multi-layer interconnect region. In some embodiments, a backside via 136 is formed through first backside dielectric layer 132 to make contact with the bottom side of fourth source or drain region 110b, and a backside conductive layer 138 is formed through second backside dielectric layer 134 to make contact with backside via 136. Backside conductive layer 138 may be one conductive layer of a plurality of parallel conductive layers in the same plane as second backside dielectric layer 134. In this manner, the bottommost surfaces of conductive layers 138 and second backside dielectric layers 134 may be coplanar with one another. Likewise, the uppermost surfaces of conductive layers 138 and second backside dielectric layers 134 may be coplanar with one another.

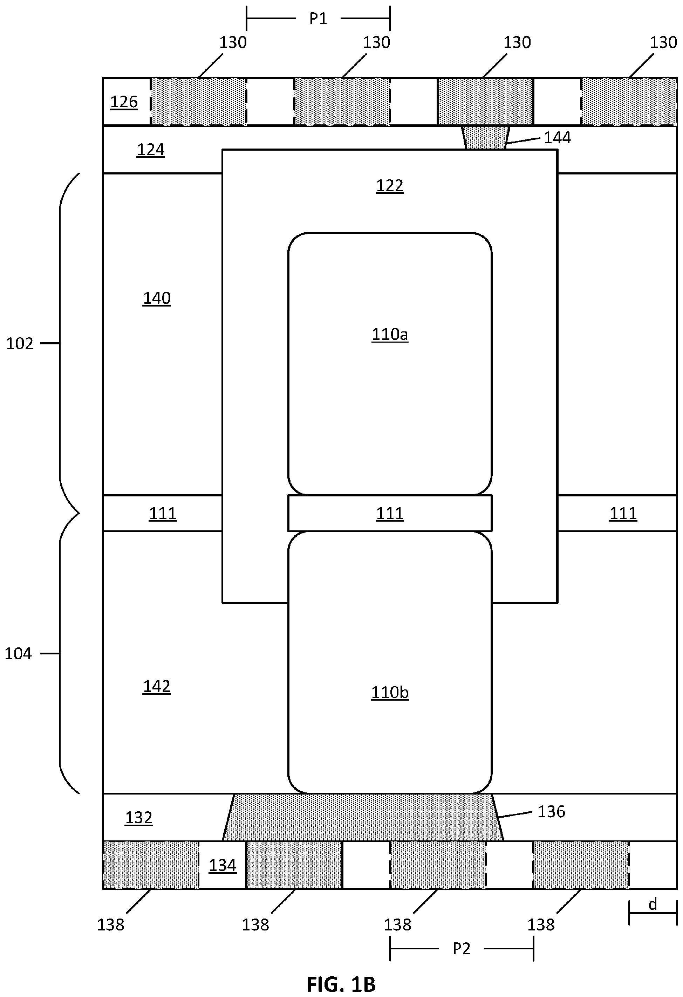

According to some embodiments, second topside contact 122 extends along the side of second source or drain region 110a to contact at least a portion of fourth source or drain region 110b. Figure 1B illustrates a cross-section view taken through the dashed line of Figure 1A. Topside contact 122 can be seen extending along an entire thickness of second source or drain region 110a and through dielectric layer 111 to contact at least a portion of fourth source or drain region 110b within the source/drain trench. According to some embodiments, second topside contact 122 also extends through a first dielectric fill 140 adjacent to second source or drain region 110a within the source/drain trench and through a second dielectric fill 142 adjacent to fourth source or drain region 110b within the same source/drain trench. Accordingly, second source or drain region 110a may be conductively coupled to fourth source or drain region 110b by second topside contact 122. Another topside via 144 may be provided between a given topside conductive layer 130 and second topside contact 122.

Figure 1B also illustrates the various topside and backside interconnect tracks. Topside conductive layers 130 extend into and out of the page (e.g., along the first direction) and are arranged parallel to one another at a first pitch P1. Note that topside conductive layers 130 may exist further into or out of the page along their given parallel tracks (in the illustrated example, those layers that are not part of the cross-section view of Figure 1B are provided with dashed lines). Similarly, backside conductive layers 138 extend into and out of the page (e.g., along the first direction) and are arranged parallel to one another at a second pitch P2. Note that backside conductive layers 138 may exist further into or out of the page along their given parallel tracks (in the illustrated example, those layers that are not part of the cross-section view of Figure 1B are provided with dashed lines). The first pitch P1 and second pitch P2 may be substantially the same pitch. In some examples, first pitch P1 and second pitch P2 are between about 15 nm and about 30 nm.

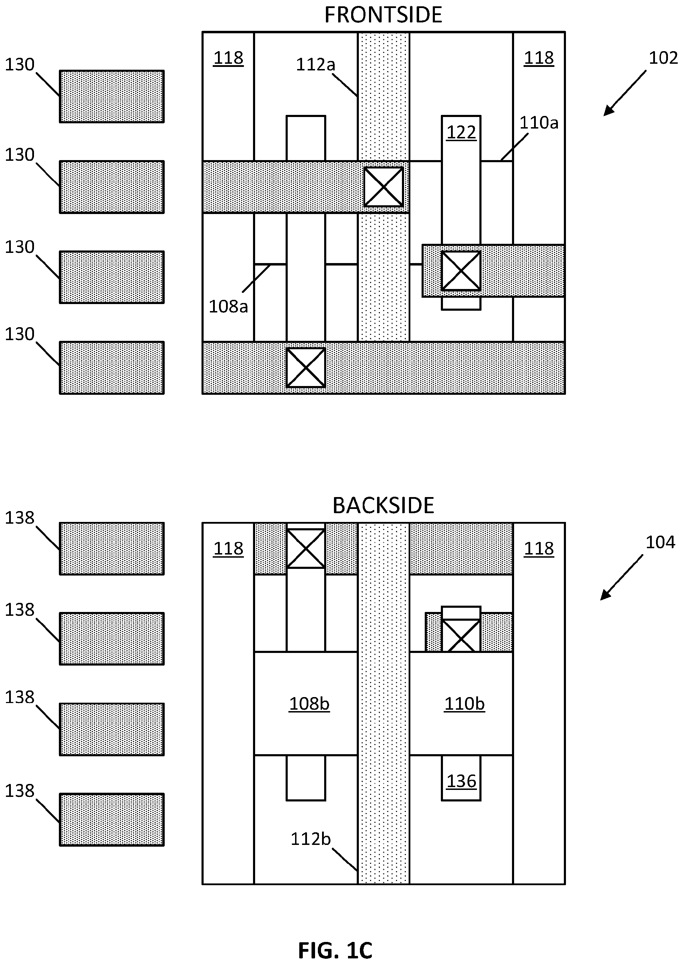

According to some embodiments, backside conductive layers 138 are offset from topside conductive layers 130 along the second direction by an offset amount d. In some examples, offset amount d is between about 4 nm and about 8 nm. In some examples, offset amount d is less than 50%, less than 40%, less than 30%, less than 20%, or less than 10% of the first pitch P1 and/or second pitch P2. According to some embodiments, offset amount d may cause one of the topside conductive layers 130 to align along one edge of the standard unit cell (e.g., a first boundary of the standard unit cell) and one of the backside conductive layers 138 to align along the opposite edge of the standard unit cell (e.g., a second boundary of the standard unit cell parallel to the first boundary). In this manner, the first pitch P1 may be aligned along (or pinned to) a first boundary of the standard unit cell, and the second pitch P2 may be aligned along (or pinned to) the second boundary of the standard unit cell. This is illustrated more clearly in Figure 1C, which provides top-down views of both the frontside and backside layouts. Along the sides of each layout, the general locations of the different topside and backside tracks are shown as topside conductive layers 130 and backside conductive layers 138. In the illustrated example, one topside conductive layer 130 is aligned along the bottom boundary of the standard unit cell and one backside conductive layer 138 is aligned along the top boundary of the standard unit cell. As further shown, the first pitch P1 is aligned along the bottom boundary of the standard unit cell, and the second pitch P2 is aligned along the top boundary of the standard unit cell. Other language may be used to describe this relationship between track pitch and cell boundary. For instance: the first pitch P1 may be keyed to, or pinned to, the bottom boundary of the standard unit cell; likewise, the second pitch P2 may be keyed to, or pinned to, the top boundary of the standard unit cell. In another example, the first pitch P1 initiates from the bottom boundary of the standard unit cell, and the second pitch P2 initiates from the top boundary of the standard unit cell. In another example, the first pitch P1 is edge-aligned to the bottom boundary of the standard unit cell, and the second pitch P2 is edge-aligned to the top boundary of the standard unit cell. A corollary of any of these may be used as well, given offset amount d. For instance, in another example, the first pitch P1 is edge-offset from the top boundary of the standard unit cell, and the second pitch P2 is edge-offset from the bottom boundary of the standard unit cell. In another such example, the first pitch P1 initiates in an offset fashion from the top boundary of the standard unit cell, and the second pitch P2 initiates in an offset fashion from the bottom boundary of the standard unit cell. Although four tracks are shown for the topside and backside interconnects, any number of tracks may be used, such as 3 tracks or 5 tracks.

### Fabrication Methodology

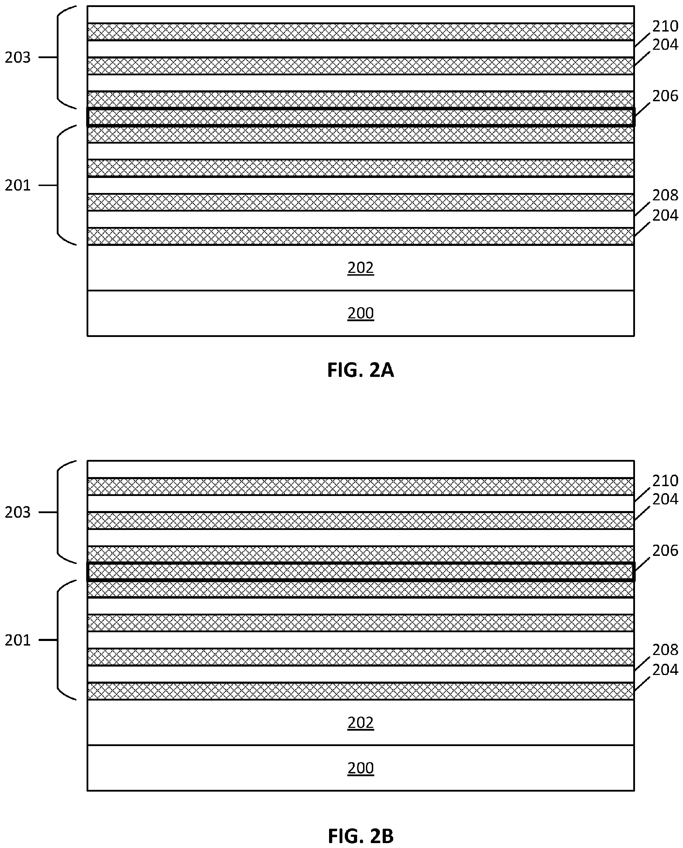

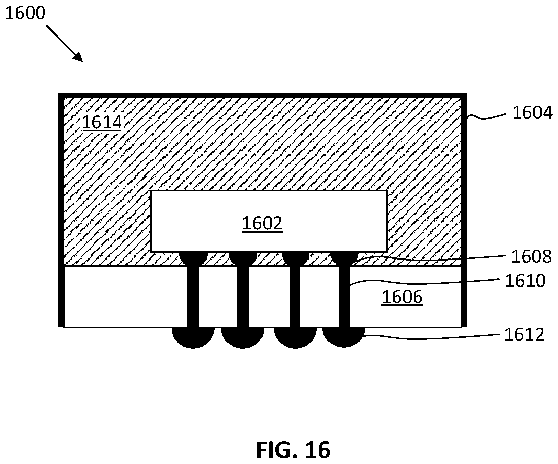

Figures 2A - 16A and 2B - 16B include cross-sectional views that collectively illustrate an example process for forming an integrated circuit that includes stacked semiconductor devices with offset topside and backside interconnect tracks, in accordance with an embodiment of the present disclosure. Figures 2A - 16A represent a similar cross-sectional view as that of Figure 1A (e.g., fin/nanoribbon direction), while Figures 2B - 16B represent a similar cross-sectional view as that of Figure 1B (e.g., along the source/drain trench). Each set of figures sharing the same letter shows an example structure that results from the process flow up to that point in time, so the depicted structure evolves as the process flow continues, culminating in the structure shown in Figures 16A and 16B, which is similar to that shown in Figures 1A and 1B. The illustrated integrated circuit structure may be part of a larger integrated circuit that includes other integrated circuitry not depicted. Example materials and process parameters are given, but other materials and process parameters may be used as well, as will be appreciated in light of this disclosure.

Figures 2A and 2B each illustrates a cross-sectional view taken through a substrate 200 with a base dielectric layer 202 on a top surface of substrate 200 and having a series of material layers formed over base dielectric layer 202, according to an embodiment of the present disclosure. Substrate 200 can be, for example, a semiconductor substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. In one example, substrate 200 is a semiconductor-on-insulator (SOI) substrate in which base dielectric layer 202 is a buried insulator layer of the SOI substrate. In some embodiments, substrate 200 has a thickness on the order of 10s or 100s of micrometers and base dielectric layer 202 has a thickness between about 100 nm and about 500 nm, or less than 1 micrometer.

Alternating material layers may be deposited over base dielectric layer 202, including a first layer stack 201, a second layer stack 203, and a spacer layer 206 between first layer stack 201 and second layer stack 203. Each of first and second layer stacks 201 and 203 includes sacrificial layers 204 alternating with other material layers, such as first semiconductor layers 208 of first layer stack 201 and second semiconductor layers 210 of second layer stack 203. Any number of alternating sacrificial layers 204 and material layers may be deposited within each of first layer stack 201 and second layer stack 203. Additionally, any number of layer stacks and spacer layers may be deposited over substrate 200.

According to some embodiments, sacrificial layers 204 have a different material composition than each of first semiconductor layers 208 and second semiconductor layers 210. In some embodiments, sacrificial layers 204 are silicon germanium (SiGe) while each of first semiconductor layers 208 and second semiconductor layers 210 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 204 and first and second semiconductor layers 208 and 210, the germanium concentration is different between sacrificial layers 204 and first and second semiconductor layers 208 and 210. For example, sacrificial layers 204 may include a higher germanium content compared to first and second semiconductor layers 208 and 210. According to some embodiments, spacer layer 206 includes the same material as sacrificial layers 204 (e.g., silicon germanium) but with a higher Ge concentration. In some examples, spacer layer 206 can be any material that exhibits a high etch selectivity with the material of semiconductor layers 208 and 210.

While dimensions can vary from one example embodiment to the next, the thickness of each sacrificial layer 204 may be between about 5 nm and about 20 nm. In some embodiments, the thickness of each sacrificial layer 204 is substantially the same (e.g., within 1-2 nm) across each of first layer stack 201 and second layer stack 203. The thickness of each of first semiconductor layers 208 and second semiconductor layers 210 may be about the same as the thickness of each sacrificial layer 204 (e.g., about 5-20 nm). However, according to some embodiments, the thickness of spacer layer 206 may be thicker than any of sacrificial layers 204. Spacer layer 206 may be provided to create a sufficient spacing between the adjacent semiconductor devices to be formed from first semiconductor layers 208 and second semiconductor layers 210. While dimensions can vary from one example embodiment to the next, the thickness of spacer layer 206 may be between about 5 nm and about 20 nm, or between about 20 nm and about 50 nm. Each of sacrificial layers 204, first semiconductor layers 208, second semiconductor layers 210, and spacer layer 206 may be deposited using any known material deposition technique, such as chemical vapor deposition (CVD), plasma-enhanced chemical vapor deposition (PECVD), physical vapor deposition (PVD), or atomic layer deposition (ALD).

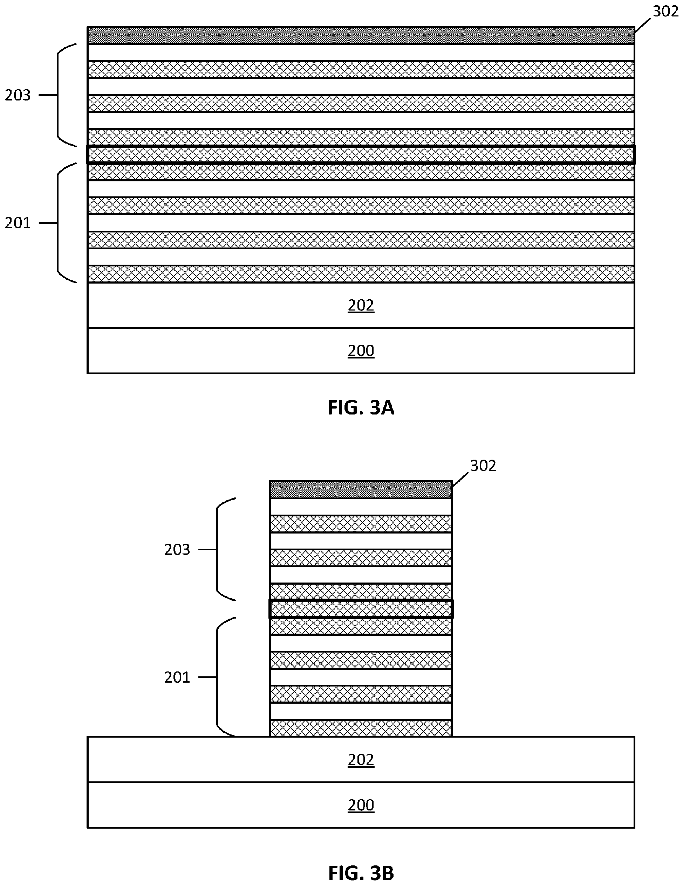

Figures 3A and 3B depict the cross-section views of the structure shown in Figures 2A and 2B, respectively, following the formation of a cap layer 302 and the subsequent formation of a fin beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stacks 201 and 203. Cap layer 302 extends along the top of each fin in a first direction, as seen in Figure 3B.

According to some embodiments, an anisotropic etching process through layer stacks 201 and 203 continues until reaching the top surface of base dielectric layer 202. In other embodiments, the etching process may continue through a portion of an underlying semiconductor substrate beneath the fin. The etched portion of the substrate may be filled with a dielectric fill that acts as shallow trench isolation (STI) between adjacent fins.

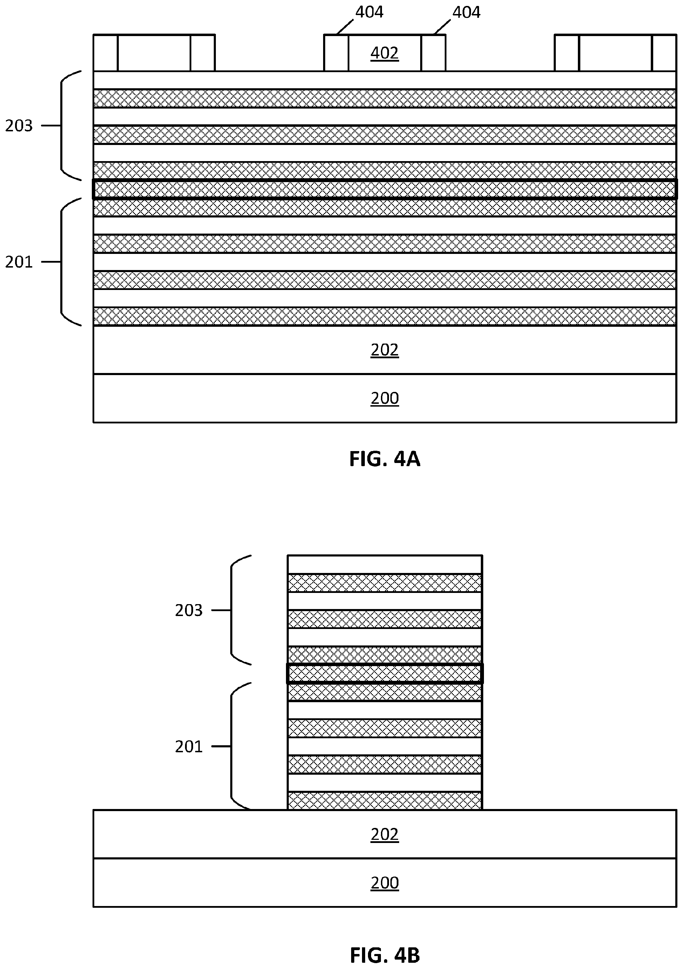

Figures 4A and 4B depict cross-section views of the structures shown in Figures 3A and 3B following the formation of sacrificial gates 402, according to some embodiments. A gate masking layer may first be patterned in strips that extend orthogonally across each of the fins (e.g., in a second direction) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gate 402 may be any material that can be selectively removed without damaging the semiconductor material of the fins. In some examples, sacrificial gate 402 includes polysilicon.

According to some embodiments, spacer structures 404 (also referred to as gate spacers or upper gate spacers) are formed along the sidewalls of sacrificial gates 402. Spacer structures 404 may be deposited and then etched back such that spacer structures 404 remain mostly only on sidewalls of any exposed structures. In the cross-section view of Figure 4B, spacer structures 404 may also be formed along sidewalls of the exposed fin over base dielectric layer 202. Such sidewall spacers on the fin can be removed during later processing when forming the source or drain regions. According to some embodiments, spacer structures 404 may be any suitable dielectric material, such as silicon nitride, silicon carbon nitride, or silicon oxycarbonitride. In one such embodiment, spacer structures 404 comprise a nitride and base dielectric layer 202 comprises an oxide, so as to provide a degree of etch selectivity during final gate processing. Other etch selective dielectric schemes (e.g., oxide/carbide, carbide/nitride) can be used as well for spacer structures 404 and base dielectric layer 202. In other embodiments, spacer structures 404 and base dielectric layer 202 are compositionally the same or otherwise similar, where etch selectivity is not employed.

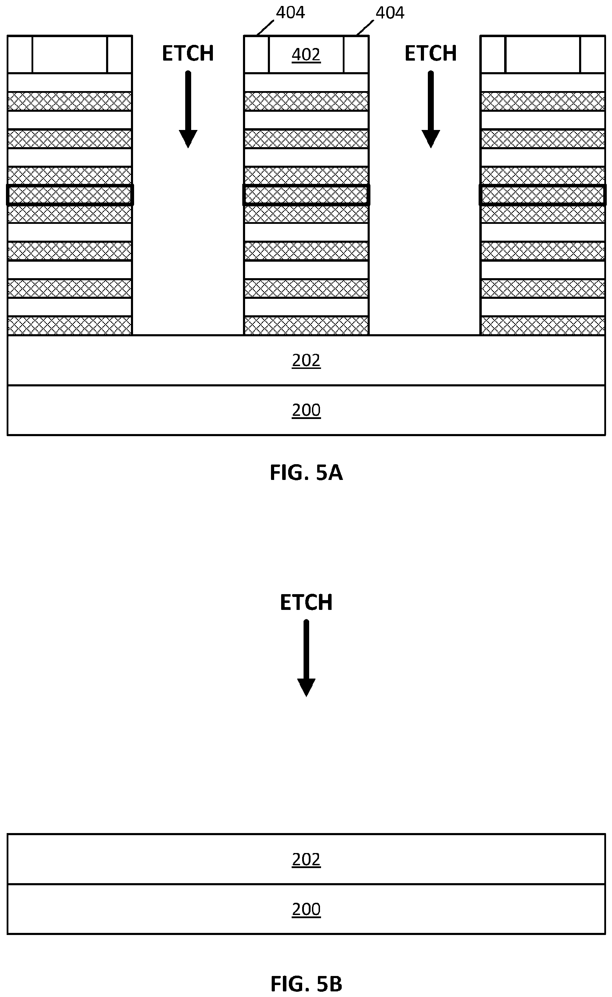

Figures 5A and 5B depict cross-section views of the structures shown in Figures 4A and 4B following the removal of exposed portions of the fins not protected by sacrificial gates 402 and spacer structures 404, according to some embodiments. The exposed fin portions may be removed using any anisotropic etching process, such as reactive ion etching (RIE). The removal of the exposed fin portions creates source or drain trenches that alternate with gate trenches (currently filled with sacrificial gates 402) along the first direction, according to some embodiments. In some embodiments, the etch proceeds through the semiconductor layers until reaching the top surface of base dielectric layer 202.

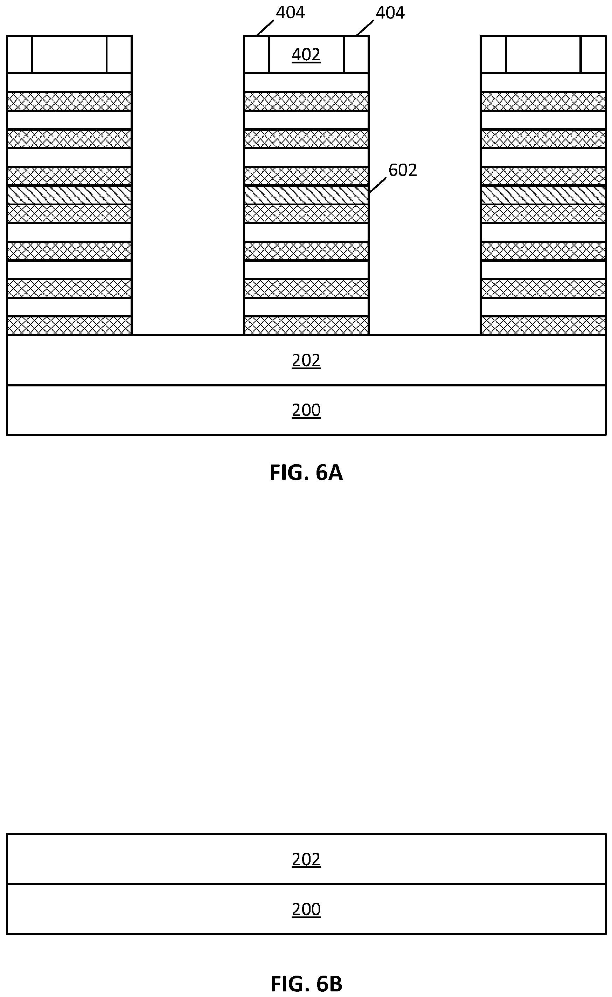

Figures 6A and 6B depict cross-section views of the structures shown in Figures 5A and 5B following the replacement of spacer layer 206 with dielectric layer 602, according to some embodiments. An isotropic etching process may be used to selectively remove spacer layer 206 due to its higher Ge concentration. A dielectric material may then be deposited using, for example, ALD or CVD to fill the regions previously occupied by spacer layer 206 in the fins. Excess portions of the dielectric material may be removed using any suitable isotropic etching process. In some examples, dielectric layer 602 includes any suitable dielectric material, such as silicon dioxide, silicon oxynitride, silicon nitride, or silicon oxycarbonitride.

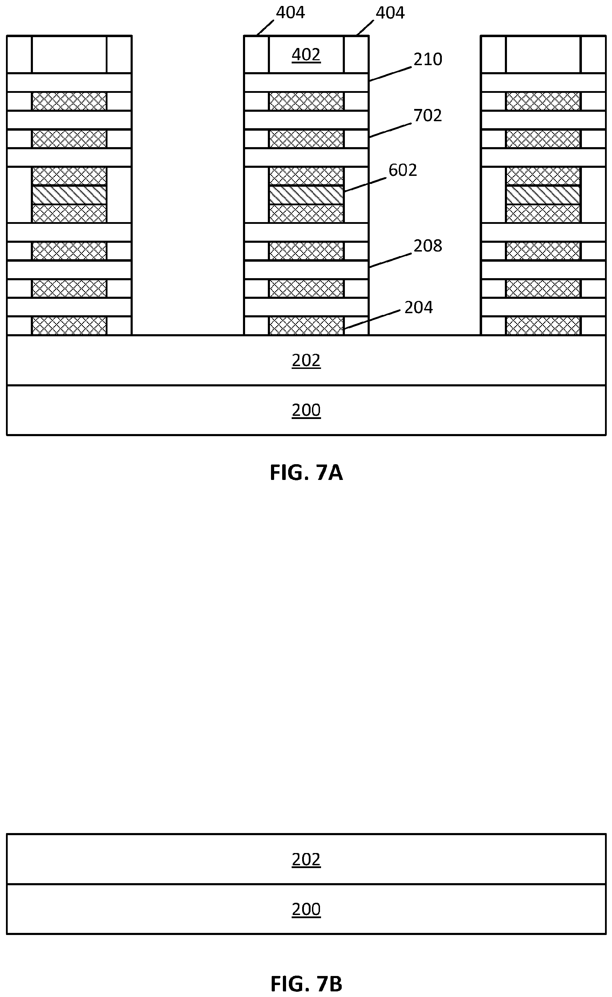

Figures 7A and 7B depict cross-section views of the structures shown in Figures 6A and 6B following the removal of portions of sacrificial layers 204 and dielectric layer 602 and subsequent formation of inner spacers 702 (sometimes called lower gate spacers), according to an embodiment of the present disclosure. An isotropic etching process may be used to selectively recess the exposed ends of each sacrificial layer 204 (e.g., while etching comparatively little of semiconductor layers 208 and 210). Another isotropic etching process may be used to selectively recess the exposed ends of dielectric layer 602. Inner spacers 702 may have a material composition that is similar to or the exact same as spacer structures 404. Accordingly, inner spacers 702 may be any dielectric material that exhibits high etch selectively to semiconductor materials such as silicon and/or silicon germanium. Inner spacers 702 may be, for example, conformally deposited over the sides of the fin structure using a conformal deposition process like CVD or ALD and then etched back using an isotropic etching process to expose the ends of first semiconductor layers 208 and second semiconductor layers 210. According to some embodiments, inner spacers 702 have a similar width (e.g., along the first direction) to spacer structures 404.

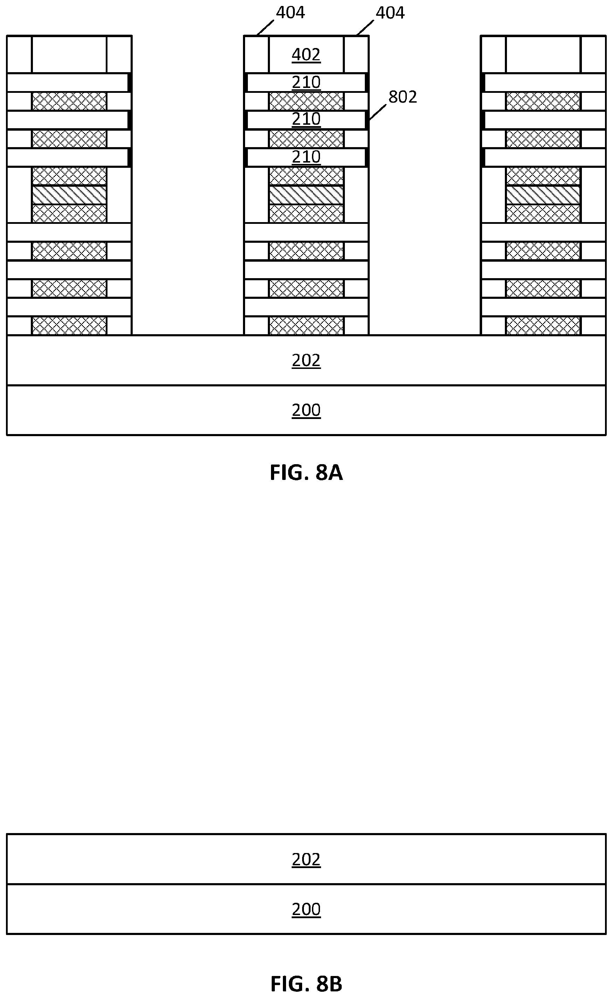

Figures 8A and 8B depict cross-section views of the structures shown in Figures 7A and 7B following the formation of a sacrificial film 802 over the ends of second semiconductor layers 210, according to some embodiments. Sacrificial film 802 may be selectively formed over the ends of second semiconductor layers 210 using any of several possible techniques. In one example, the bottom of the source/drain trench is filled with a sacrificial material, such as carbon hard mask (CHM), to protect the ends of first semiconductor layers 208 while the ends of second semiconductor layers 210 are laterally recessed using an isotropic etching process. The CHM may then be removed followed by the deposition of a sacrificial material and subsequent etching back of the sacrificial material using any suitable isotropic etching process. The result of the etch-back process yields sacrificial film 802 within the laterally etched recesses over the ends of second semiconductor layers 210. According to some embodiments, sacrificial film 802 includes any suitable material that can be safely removed at a later time without damaging or substantially etching any other transistor elements. In some examples, sacrificial film 802 includes aluminum oxide or titanium nitride.

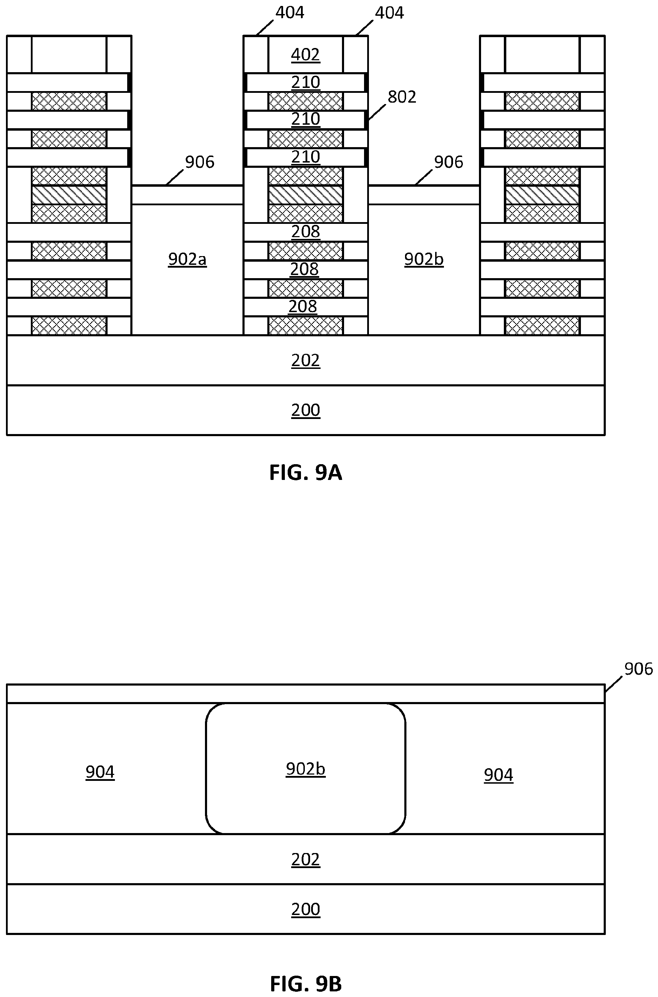

Figures 9A and 9B depict cross-section views of the structure shown in Figures 8A and 8B, respectively, following the formation of first source or drain region 902a and second source or drain region 902b within the bottom of the source/drain trenches, according to some embodiments. According to some embodiments, first and second source or drain regions 902a/902b are epitaxially grown from the exposed semiconductor material at the ends of first semiconductor layers 208, while the ends of second semiconductor layers 210 are blocked by sacrificial film 802. In some example embodiments, first and second source or drain regions 902a/902b are PMOS source or drain regions (e.g., epitaxial silicon germanium) or are NMOS source or drain regions (e.g., epitaxial silicon).

According to some embodiments, and as seen in Figure 7B, a first dielectric fill 904 is provided within the source/drain trenches adjacent to first and second source or drain regions 902a/902b. In some examples, first dielectric fill 904 occupies a remaining volume directly adjacent to first and second source or drain regions 902a/902b within the source/drain trenches. First dielectric fill 904 may be any dielectric material, such as silicon dioxide. In some examples, first dielectric fill 904 extends up to and substantially planar with a top surface of first and second source or drain regions 902a/902b. A dielectric layer 906 may be formed over the top surfaces of first and second source or drain regions 902a/902b within the source/drain trenches, according to some embodiments. Dielectric layer 906 may be substantially the same material as first dielectric fill 904 and may have a thickness between about 10 nm and about 30 nm. In some embodiments, first dielectric fill 904 extends over the top surfaces of first and second source or drain regions 902a/902b, such that there is no need for a separately formed dielectric layer 906.

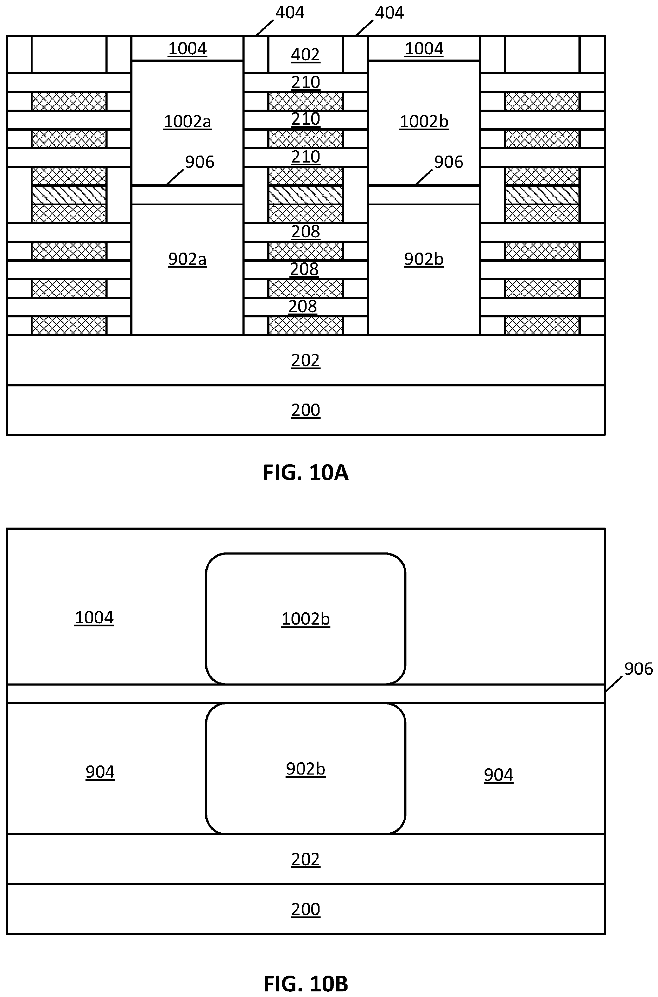

Figures 10A and 10B depict cross-section views of the structure shown in Figures 9A and 9B, respectively, following the formation of third source or drain region 1002a and fourth source or drain region 1002b within the top of the source/drain trenches, according to some embodiments. According to some embodiments, third and fourth source or drain regions 1002a/1002b are epitaxially grown from the exposed semiconductor material at the ends of second semiconductor layers 210, following the removal of sacrificial film 802. In some example embodiments, third and fourth source or drain regions 1002a/1002b are NMOS source or drain regions (e.g., epitaxial silicon) or are PMOS source or drain regions (e.g., epitaxial silicon germanium). In one example, first and second source or drain regions 902a/902b are p-type source or drain regions and third and fourth source or drain regions 1002a/1002b are n-type source or drain regions.

According to some embodiments, and as seen in Figure 7B, a second dielectric fill 1004 is provided within the source/drain trenches adjacent to third and fourth source or drain regions 1002a/1002b. In some examples, second dielectric fill 1004 occupies a remaining volume adjacent to and over the top of third and fourth source or drain regions 1002a/1002b within the source/drain trenches. Second dielectric fill 1004 may be any dielectric material, such as silicon dioxide. In some examples, second dielectric fill 1004 extends up to and substantially coplanar with a top surface of spacer structures 404. A top surface of second dielectric fill 1004 may be polished using, for example, chemical mechanical polishing (CMP) to provide its planar top surface.

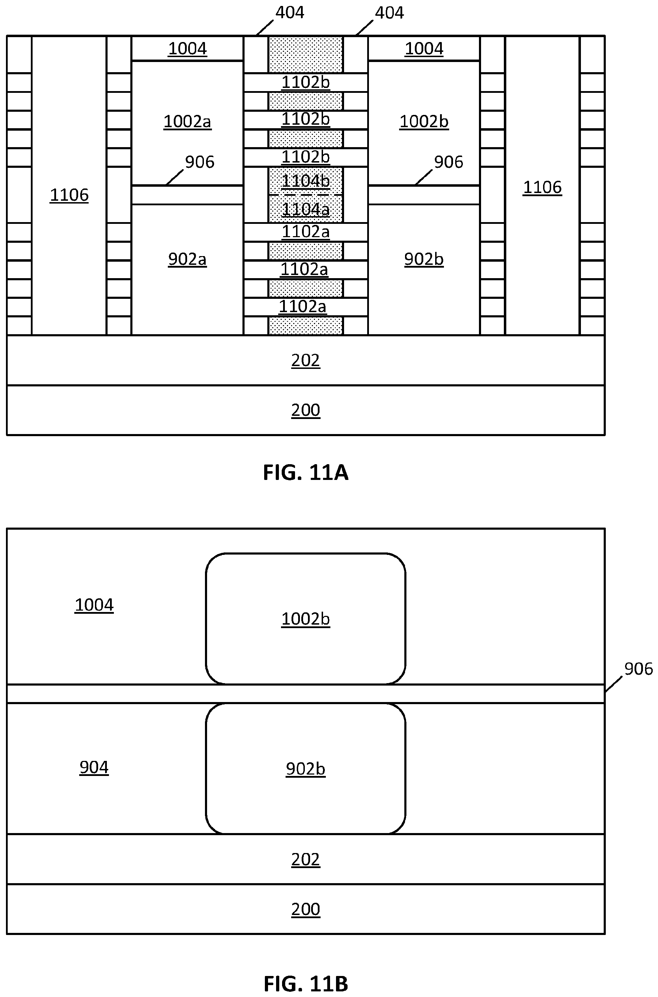

Figures 11A and 11B depict cross-section views of the structure shown in Figures 10A and 10B, respectively, following the removal of sacrificial gates 402 and sacrificial layers 204, and the subsequent formation of gate structure(s), according to some embodiments. In examples where gate masking layers are still present, they would be removed at this time. Once sacrificial gates 402 are removed, the fin extending between spacer structures 404 is exposed.

In the example where the fin includes alternating semiconductor layers, sacrificial layers 204 are selectively removed to leave behind first nanoribbons 1102a that extend between corresponding first and second source or drain regions 902a/902b and second nanoribbons 1102b that extend between corresponding third and fourth source or drain regions 1002a/1002b. Each vertical set of nanoribbons 1102a/1102b represents the semiconductor region (or channel region) of a different semiconductor device. Note that nanoribbons 1102a/1102b may have any geometry and the use of the term nanoribbon is not intended to exclude any particular geometries usable for a gate-all-around channel region (such as nanowires). Sacrificial gates 402 and sacrificial layers 204 may be removed using the same isotropic etching process or different isotropic etching processes. According to some embodiments, dielectric layer 602 is also removed using a suitable isotropic etching process, such that first nanoribbons 1102a and second nanoribbons 1102b are the only structures extending the entire distance across the gate trench along the first direction.

According to some embodiments, the gate structure includes a first gate portion 1104a and a second gate portion 1104b. The gate portions 1104a/1104b may be considered part of a single gate structure or may be considered as separate gate structures. Each gate portion 1104a/1104b includes a gate dielectric and a gate electrode. The gate dielectric may be first formed around nanoribbons 1102a/1102b prior to the formation of the gate electrode, which may include one or more conductive layers. The gate dielectric may include any gate dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on nanoribbons 1102a/1102b, and a second layer on the first layer. The first layer can be, for instance, an oxide of the semiconductor material of nanoribbons 1102a/1102b (e.g., silicon dioxide) and the second layer can be a high-k dielectric material (e.g., hafnium oxide).

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. According to some embodiments, first gate portion 1104a includes p-type workfunction materials (e.g., titanium nitride) to form a PMOS gates, and second gate portion 1104b includes n-type workfunction materials (e.g., titanium aluminum carbide) to form an NMOS gate.

According to some embodiments, an RIE process is used to remove the gate structures on either side of the illustrated gate structure and fill those gate trenches with a dielectric material to form isolation structures 1106. Isolation structures 1106 may include one or more dielectric materials that extend in the second direction within their respective gate trenches to cut through any number of fins present within those gate trenches. In the illustrated example, isolation structures 1106 extend along the second direction on either side of the stacked NMOS and PMOS devices to isolate such devices from any other devices formed along the first direction. Isolation structures 1106 may include any suitable dielectric material, such as silicon nitride or any other oxide-based dielectric material. According to some embodiments, isolation structures 1106 extend in the third direction along at least an entire height of the adjacent source or drain regions. A top surface of isolation structures 1106 may be substantially coplanar with a top surface of spacer structures 404 and/or second dielectric fill 1004. Isolation structures 1106 may not be needed in situations where adjacent devices along the first direction are intended to share a given source or drain region (or where dummy transistors are employed).

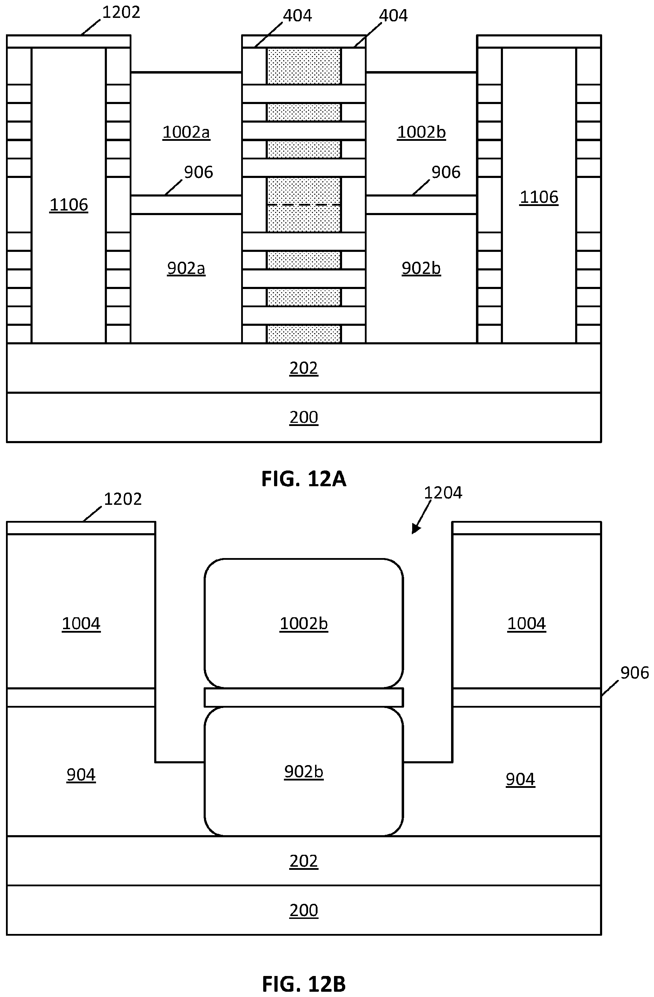

Figures 12A and 12B depict cross-section views of the structure shown in Figures 11A and 11B, respectively, following the removal of portions of second dielectric fill 1004 over third source or drain region 1002a and fourth source or drain region 1002b, according to some embodiments. A first topside dielectric layer 1202 may be formed over the structure prior to the removal of second dielectric fill 1004. A masked RIE process may be used to etch through first topside dielectric layer 1202 and through portions of second dielectric fill 1004 around third source or drain region 1002a and fourth source or drain region 1002b to expose at least top surfaces of third source or drain region 1002a and fourth source or drain region 1002b. First topside dielectric layer 1202 may include any suitable dielectric material, such as silicon dioxide.

According to some embodiments, the RIE process around fourth source or drain region 1002b continues deeper through dielectric layer 906 and into at least a portion of first dielectric fill 904 to form recess 1204. As a result, portions of both fourth source or drain region 1002b and second source or drain region 902b are exposed within recess 1204. For example, a top surface and sidewall surfaces of fourth source or drain region 1002b are exposed and portions of sidewall surfaces of second source or drain region 902b are exposed. Note that dielectric layer 906 may still exist between fourth source or drain region 1002b and second source or drain region 902b.

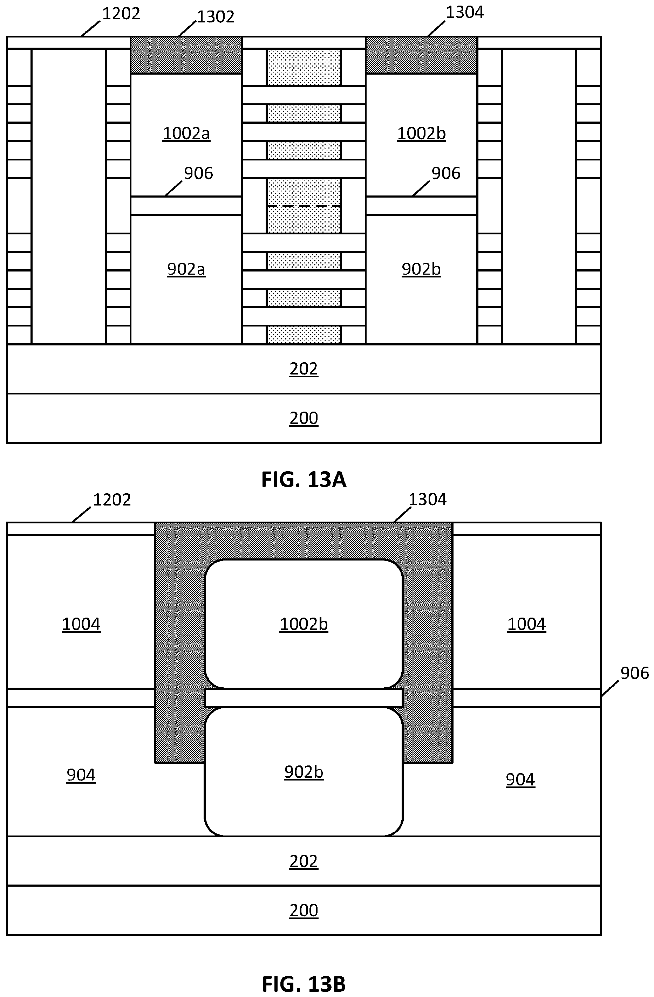

Figures 13A and 13B depict cross-section views of the structure shown in Figures 12A and 12B, respectively, following the formation of a first topside contact 1302 over third source or drain region 1002a and a second topside contact 1304 over fourth source or drain region 1002b, according to some embodiments. First topside contact 1302 and second topside contact 1304 may each include any suitable conductive material, such as ruthenium, tungsten, cobalt, or molybdenum, to name a few examples. According to some embodiments, second topside contact 1304 substantially fills recess 1204, such that second topside contact 1304 extends along the third direction to contact portions of both fourth source or drain region 1002b and second source or drain region 902b. Top surfaces of first topside contact 1302 and second topside contact 1304 may be polished such that they are substantially coplanar with top a surface of first dielectric layer 1202.

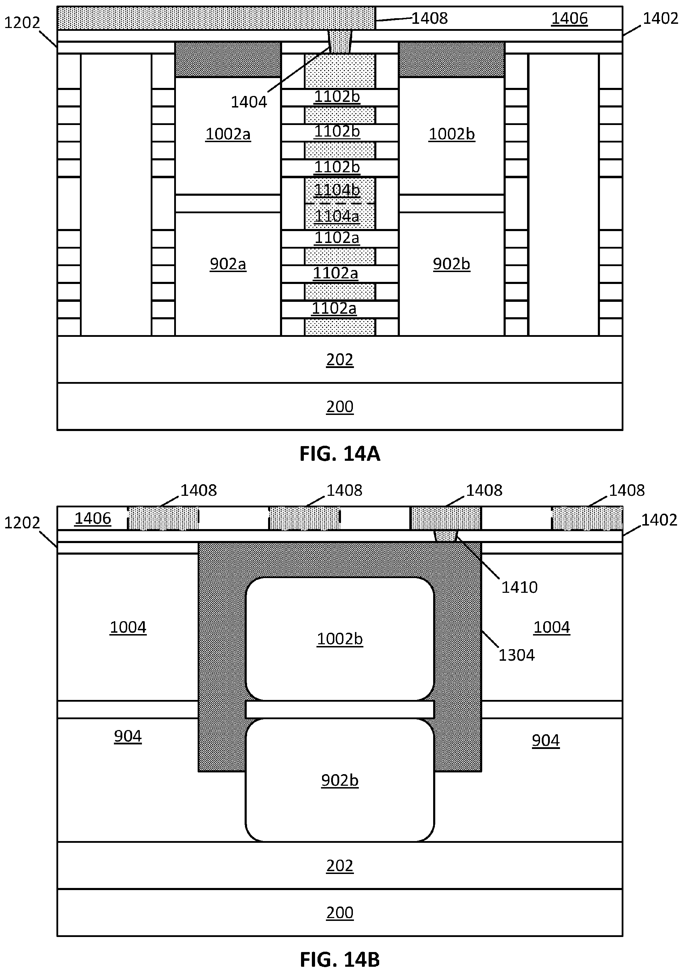

Figures 14A and 14B depict cross-section views of the structure shown in Figures 13A and 13B, respectively, following the formation of topside interconnect layers, according to some embodiments. A first topside interconnect layer includes first topside dielectric layer 1202, a second topside dielectric layer 1402, and a first topside via 1404 extending through both first topside dielectric layer 1202 and second topside dielectric layer 1402. In some examples, first topside via 1404 contacts a top surface of second gate portion 1104b. A second topside via 1410 may also be formed through second topside dielectric layer 1402 to contact a top surface of second topside contact 1304. A second topside interconnect layer includes a third topside dielectric layer 1406 on second topside dielectric layer 1402, and a topside conductive layer 1408. According to some embodiments, topside conductive layer 1408 is one conductive layer of a plurality of similar topside conductive layers that extend lengthwise along the first direction and parallel to one another, as seen more clearly in Figure 14B. Note in the illustration that second topside via 1410 may contact a given topside conductive layer 1408 (solid outline) while other topside conductive layers 1408 exist either further into or out of the page along the first direction (dashed outlines). One of the topside conductive layers 1408 may be aligned along a boundary of a standard unit cell (e.g., righthand boundary in the illustration of Figure 14B). First topside via 1404, second topside via 1410, and topside conductive layers 1408 may include any suitable conductive material, such as ruthenium, tungsten, cobalt, or molybdenum.

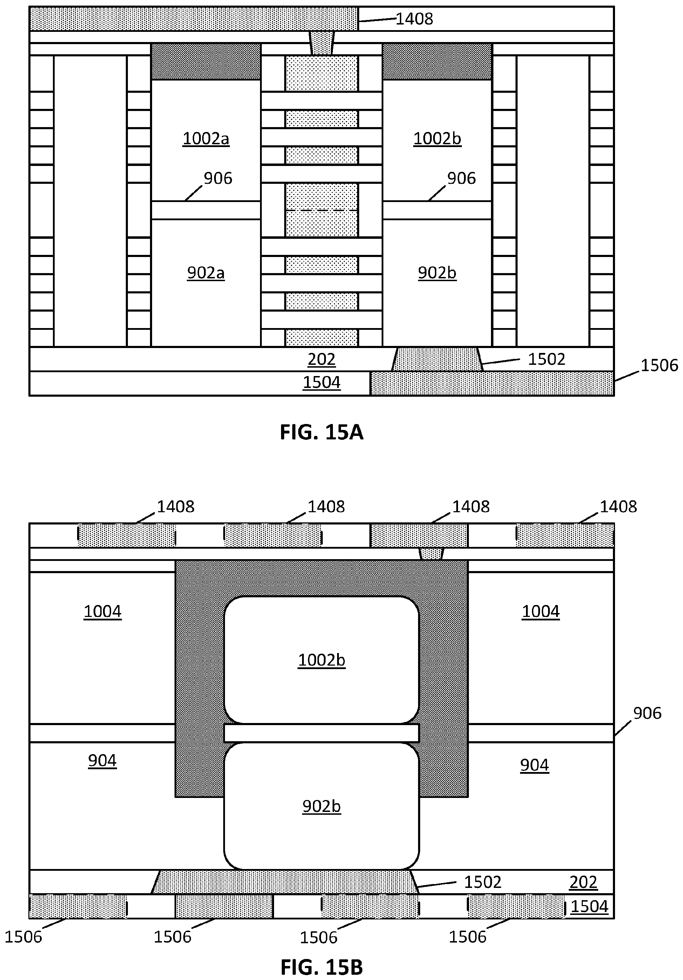

Figures 15A and 15B depict cross-section views of the structure shown in Figures 14A and 14B, respectively, following the removal of substrate 200 and subsequent formation of backside interconnect layers, according to some embodiments. Following the completion of all topside interconnect layers (e.g., FEOL structures), a substrate 200 is removed using, for example, CMP and/or vapor phase etchants. The remaining base dielectric layer 202 may be thinned or may be removed and replaced with another backside dielectric layer. In any case, any number of backside interconnect layers are formed beneath the semiconductor devices.

Following the removal of substrate 200, any number of backside interconnect layers may be formed. According to some embodiments, a first backside interconnect layer includes base dielectric layer 202 and a backside via 1502 extending through base dielectric layer 202. In some examples, backside via 1502 contacts a bottom surface of second source or drain region 902b. A second backside interconnect layer includes a backside dielectric layer 1504 on base dielectric layer 202, and a backside conductive layer 1506. According to some embodiments, backside conductive layer 1506 is one conductive layer of a plurality of similar backside conductive layers that extend lengthwise along the first direction and parallel to one another, as seen more clearly in Figure 15B. Note in the illustration that backside via 1502 may extend along the second direction to contact a given backside conductive layer 1506 (solid outline) while other backside conductive layers 1506 exist either further into or out of the page along the first direction (dashed outlines).

One of the backside conductive layers 1506 may be aligned along a boundary of a standard unit cell (e.g., lefthand boundary in the illustration of Figure 15B). According to some embodiments, backside conductive layers 1506 are offset from topside conductive layers 1408 along the second direction and may include the same pitch along the second direction as topside conductive layers 1408. The offset amount may be between about 4 nm and about 8 nm. In some examples, the offset amount is less than 50%, less than 40%, less than 30%, less than 20%, or less than 10% of the pitch between backside conductive layers 1506 or the pitch between topside conductive layers 1408.

Figure 16 illustrates an example embodiment of a chip package 1600, in accordance with an embodiment of the present disclosure. As can be seen, chip package 1600 includes one or more dies 1602. One or more dies 1602 may include at least one integrated circuit having semiconductor devices, such as any of the semiconductor devices disclosed herein. One or more dies 1602 may include any other circuitry used to interface with other devices formed on the dies, or other devices connected to chip package 1600, in some example configurations.

As can be further seen, chip package 1600 includes a housing 1604 that is bonded to a package substrate 1606. The housing 1604 may be any standard or proprietary housing, and may provide, for example, electromagnetic shielding and environmental protection for the components of chip package 1600. The one or more dies 1602 may be conductively coupled to a package substrate 1606 using connections 1608, which may be implemented with any number of standard or proprietary connection mechanisms, such as solder bumps, ball grid array (BGA), pins, or wire bonds, to name a few examples. Package substrate 1606 may be any standard or proprietary package substrate, but in some cases includes a dielectric material having conductive pathways (e.g., including conductive vias and lines) extending through the dielectric material between the faces of package substrate 1606, or between different locations on each face. In some embodiments, package substrate 1606 may have a thickness less than 1 millimeter (e.g., between 0.1 millimeters and 0.5 millimeters), although any number of package geometries can be used. Additional conductive contacts 1612 may be disposed at an opposite face of package substrate 1606 for conductively contacting, for instance, a printed circuit board (PCB). One or more vias 1610 extend through a thickness of package substrate 1606 to provide conductive pathways between one or more of connections 1608 to one or more of contacts 1612. Vias 1610 are illustrated as single straight columns through package substrate 1606 for ease of illustration, although other configurations can be used (e.g., damascene, dual damascene, through-silicon via, or an interconnect structure that meanders through the thickness of substrate 1606 to contact one or more intermediate locations therein). In still other embodiments, vias 1610 are fabricated by multiple smaller stacked vias, or are staggered at different locations across package substrate 1606. In the illustrated embodiment, contacts 1612 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1612, to inhibit shorting.

In some embodiments, a mold material 1614 may be disposed around the one or more dies 1602 included within housing 1604 (e.g., between dies 1602 and package substrate 1606 as an underfill material, as well as between dies 1602 and housing 1604 as an overfill material). Although the dimensions and qualities of the mold material 1614 can vary from one embodiment to the next, in some embodiments, a thickness of mold material 1614 is less than 1 millimeter. Example materials that may be used for mold material 1614 include epoxy mold materials, as suitable. In some cases, the mold material 1614 is thermally conductive, in addition to being electrically insulating.

### Example System

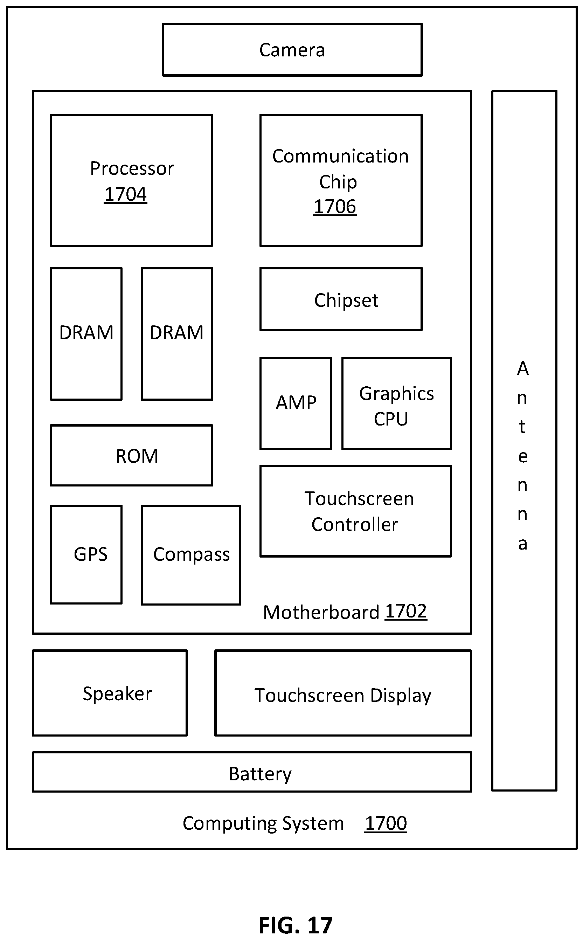

Figure 17 is an example computing system implemented with one or more of the integrated circuit structures as disclosed herein, in accordance with some embodiments of the present disclosure. As can be seen, the computing system 1700 houses a motherboard 1702. The motherboard 1702 may include a number of components, including, but not limited to, a processor 1704 and at least one communication chip 1706, each of which can be physically and electrically coupled to the motherboard 1702, or otherwise integrated therein. As will be appreciated, the motherboard 1702 may be, for example, any printed circuit board (PCB), whether a main board, a daughterboard mounted on a main board, or the only board of system 1700, etc.

Depending on its applications, computing system 1700 may include one or more other components that may or may not be physically and electrically coupled to the motherboard 1702. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1700 may include one or more integrated circuit structures or devices configured in accordance with an example embodiment (e.g., a module including an integrated circuit having a stacked configuration of semiconductor devices with offset topside and backside interconnect tracks, as variously provided herein). In some embodiments, multiple functions can be integrated into one or more chips (e.g., for instance, note that the communication chip 1706 can be part of or otherwise integrated into the processor 1704).

The communication chip 1706 enables wireless communications for the transfer of data to and from the computing system 1700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1700 may include a plurality of communication chips 1706. For instance, a first communication chip 1706 may be dedicated to shorter range wireless communications such as Wi-Fi and Bluetooth and a second communication chip 1706 may be dedicated to longer range wireless communications such as GPS, EDGE, GPRS, CDMA, WiMAX, LTE, Ev-DO, and others.

The processor 1704 of the computing system 1700 includes an integrated circuit die packaged within the processor 1704. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1706 also may include an integrated circuit die packaged within the communication chip 1706. In accordance with some such example embodiments, the integrated circuit die of the communication chip includes one or more semiconductor devices as variously described herein. As will be appreciated in light of this disclosure, note that multi-standard wireless capability may be integrated directly into the processor 1704 (e.g., where functionality of any chips 1706 is integrated into processor 1704, rather than having separate communication chips). Further note that processor 1704 may be a chip set having such wireless capability. In short, any number of processor 1704 and/or communication chips 1706 can be used. Likewise, any one chip or chip set can have multiple functions integrated therein.

In various implementations, the computing system 1700 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1700 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor region extending from a first source or drain region to a second source or drain region in a first direction, a second semiconductor region extending from a third source or drain region to a fourth source or drain region in the first direction, and a gate structure extending over the first semiconductor region and the second semiconductor region in a second direction substantially orthogonal to the first direction. The first source or drain region is spaced from the third source or drain region in a third direction substantially orthogonal to the first and second directions, and the second source or drain region is spaced from the fourth source or drain region in the third direction. The integrated circuit also includes a first plurality of conductive layers above the first semiconductor region and extending lengthwise along the first direction and a second plurality of conductive layers below the second semiconductor region and extending lengthwise along the first direction. The first plurality of conductive layers are separated from one another along the second direction by a first pitch, and the second plurality of conductive layers are separated from one another along the second direction by a second pitch. The first plurality of conductive layers are offset from the second plurality of conductive layers along the second direction by between 1 nm and 5 nm.

Example 2 includes the integrated circuit of Example 1, wherein the first and second source or drain regions are n-type source or drain regions and the third and fourth source or drain regions are p-type source or drain regions.

Example 3 includes the integrated circuit of Example 2, wherein the first and second source or drain regions comprise silicon and phosphorous and the third and fourth source or drain regions comprise silicon, germanium, and boron.

Example 4 includes the integrated circuit of any one of Examples 1-3, wherein the first semiconductor region comprises one or more first semiconductor nanoribbons and the second semiconductor region comprises one or more second semiconductor nanoribbons.

Example 5 includes the integrated circuit of Example 4, wherein the one or more first semiconductor nanoribbons and the one or more second semiconductor nanoribbons comprises germanium, silicon, or any combination thereof.

Example 6 includes the integrated circuit of any one of Examples 1-5, wherein a first conductive layer of the first plurality of conductive layers is aligned along a first boundary of a standard unit cell that includes the first semiconductor region and the second semiconductor region, and a second conductive layer of the second plurality of conductive layers is aligned along a second boundary of the standard unit cell, the second boundary being parallel to the first boundary.

Example 7 includes the integrated circuit of Example 6, further comprising: a topside contact on a top surface of the first source or drain region; and a via extending in the third direction from the topside contact to the first conductive layer.

Example 8 includes the integrated circuit of Example 6 or 7, further comprising: a backside contact on a bottom surface of the third source or drain region; and a via extending in the third direction from the backside contact to the second conductive layer.

Example 9 includes the integrated circuit of any one of Examples 1-8, further comprising a conductive contact on at least a portion of a top surface of the second source or drain region and extending in the third direction to contact at least a portion of a side surface of the fourth source or drain region.

Example 10 includes the integrated circuit of any one of Examples 1-9, further comprising: a first dielectric layer between the first source or drain and the third source or drain region along the third direction; and a second dielectric layer between the second source or drain and the fourth source or drain region along the third direction.

Example 11 includes the integrated circuit of any one of Examples 1-10, wherein the gate structure comprises a first portion around the first semiconductor region comprising a first conductive material and a second portion around the second semiconductor region comprising a second conductive material that is not present in the first portion of the gate structure.

Example 12 includes the integrated circuit of any one of Examples 1-11, wherein the first pitch is substantially the same as the second pitch.

Example 13 includes the integrated circuit of any one of Examples 1-12, wherein the first direction is substantially orthogonal to the second direction, and the third direction is substantially orthogonal to the first and second directions.

Example 14 includes the integrated circuit of any one of Examples 1-13, wherein the first pitch is edge-aligned along a first boundary of a standard unit cell that includes the first semiconductor region and the second semiconductor region, and the second pitch is edge-aligned along a second boundary of the standard unit cell, the second boundary being parallel to the first boundary.

Example 15 is a die that includes the integrated circuit of any one of Examples 1-14.

Example 16 is an electronic device that includes one or more dies. At least one of the one or more dies includes a first semiconductor device comprising a first semiconductor region extending from a first source or drain region to a second source or drain region in a first direction and a first portion of a gate structure extending over the first semiconductor region in a second direction substantially orthogonal to the first direction, and a second semiconductor device comprising a second semiconductor region extending from a third source or drain region to a fourth source or drain region in the first direction and a second portion of the gate structure extending over the second semiconductor region in the second direction. The first source or drain region is spaced from the third source or drain region in a third direction substantially orthogonal to the first and second directions, and the second source or drain region is spaced from the fourth source or drain region in the third direction. The at least one of the one or more dies further includes a first plurality of conductive layers above the first semiconductor region and extending lengthwise along the first direction and a second plurality of conductive layers below the second semiconductor region and extending lengthwise along the first direction. The first plurality of conductive layers are separated from one another along the second direction by a first pitch, and the second plurality of conductive layers are separated from one another along the second direction by a second pitch. The first plurality of conductive layers are offset from the second plurality of conductive layers along the second direction by between 1 nm and 5 nm.

Example 17 includes the electronic device of Example 16, wherein the first and second source or drain regions are n-type source or drain regions and the third and fourth source or drain regions are p-type source or drain regions.

Example 18 includes the electronic device of Example 17, wherein the first and second source or drain regions comprise silicon and phosphorous and the third and fourth source or drain regions comprise silicon, germanium, and boron.

Example 19 includes the electronic device of any one of Examples 16-18, wherein the first semiconductor region comprises one or more first semiconductor nanoribbons and the second semiconductor region comprises one or more second semiconductor nanoribbons.

Example 20 includes the electronic device of Example 19, wherein the one or more first semiconductor nanoribbons and the one or more second semiconductor nanoribbons comprises germanium, silicon, or any combination thereof.

Example 21 includes the electronic device of any one of Examples 16-20, wherein a first conductive layer of the first plurality of conductive layers is aligned along a first boundary of a standard unit cell that includes the first semiconductor device and the second semiconductor device, and a second conductive layer of the second plurality of conductive layers is aligned along a second boundary of the standard unit cell, the second boundary being parallel to the first boundary.

Example 22 includes the electronic device of Example 21, wherein the at least one of the one or more dies further comprises: a topside contact on a top surface of the first source or drain region; and a via extending in the third direction from the topside contact to the first conductive layer.

Example 23 includes the electronic device of Example 21 or 22, wherein the at least one of the one or more dies further comprises: a backside contact on a bottom surface of the third source or drain region; and a via extending in the third direction from the backside contact to the second conductive layer.

Example 24 includes the electronic device of any one of Examples 16-23, wherein the at least one of the one or more dies further comprises a conductive contact on at least a portion of a top surface of the second source or drain region and extending in the third direction to contact at least a portion of a side surface of the fourth source or drain region.

Example 25 includes the electronic device of any one of Examples 16-24, wherein the at least one of the one or more dies further comprises: a first dielectric layer between the first source or drain and the third source or drain region along the third direction; and a second dielectric layer between the second source or drain and the fourth source or drain region along the third direction.

Example 26 includes the electronic device of any one of Examples 16-25, wherein the first portion of the gate structure comprises a first conductive material and the second portion of the gate structure comprises a second conductive material that is not present in the first portion of the gate structure.

Example 27 includes the electronic device of any one of Examples 16-26, wherein the first pitch is substantially the same as the second pitch.

Example 28 includes the electronic device of any one of Examples 16-27, further comprising a printed circuit board, wherein the chip package is attached to the printed circuit board.

Example 29 is an integrated circuit that includes a standard unit cell having a first semiconductor device and a second semiconductor device. The standard unit cell includes a layout that is repeated across at least a portion of the integrated circuit. The first semiconductor device includes a first semiconductor region extending from a first source or drain region to a second source or drain region in a first direction, and a first portion of a gate structure extending over the first semiconductor region in a second direction substantially orthogonal to the first direction. The second semiconductor device includes a second semiconductor region extending from a third source or drain region to a fourth source or drain region in the first direction, and a second portion of the gate structure extending over the second semiconductor region in the second direction. The first source or drain region is spaced from the third source or drain region in a third direction substantially orthogonal to the first and second directions, and the second source or drain region is spaced from the fourth source or drain region in the third direction. The integrated circuit also includes a first plurality of parallel conductive layers above the first semiconductor device, and a second plurality of parallel conductive layers below the second semiconductor device. The first plurality of conductive layers are offset from the second plurality of conductive layers along the first direction or along the second direction. A first conductive layer of the first plurality of conductive layers is aligned along a first boundary of the standard unit cell, and a second conductive layer of the second plurality of conductive layers is aligned along a second boundary of the standard unit cell. The second boundary is parallel to the first boundary.

Example 30 includes the integrated circuit of Example 29, wherein the first and second source or drain regions are n-type source or drain regions and the third and fourth source or drain regions are p-type source or drain regions.

Example 31 includes the integrated circuit of Example 30, wherein the first and second source or drain regions comprise silicon and phosphorous and the third and fourth source or drain regions comprise silicon, germanium, and boron.

Example 32 includes the integrated circuit of any one of Examples 29-31, wherein the first semiconductor region comprises one or more first semiconductor nanoribbons and the second semiconductor region comprises one or more second semiconductor nanoribbons.

Example 33 includes the integrated circuit of Example 32, wherein the one or more first semiconductor nanoribbons and the one or more second semiconductor nanoribbons comprises germanium, silicon, or any combination thereof.

Example 34 includes the integrated circuit of any one of Examples 29-33, further comprising: a topside contact on a top surface of the first source or drain region; and a via extending in the third direction from the topside contact to the first conductive layer.

Example 35 includes the integrated circuit of any one of Examples 29-34, further comprising: a backside contact on a bottom surface of the third source or drain region; and a via extending in the third direction from the backside contact to the second conductive layer.

Example 36 includes the integrated circuit of any one of Examples 29-35, further comprising a conductive contact on at least a portion of a top surface of the second source or drain region and extending in the third direction to contact at least a portion of a side surface of the fourth source or drain region.

Example 37 includes the integrated circuit of any one of Examples 29-36, further comprising: a first dielectric layer between the first source or drain and the third source or drain region along the third direction; and a second dielectric layer between the second source or drain and the fourth source or drain region along the third direction.

Example 38 includes the integrated circuit of any one of Examples 29-37, wherein the first portion of the gate structure comprises a first conductive material and the second portion of the gate structure comprises a second conductive material that is not present in the first portion of the gate structure.

Example 39 includes the integrated circuit of any one of Examples 29-38, wherein the first plurality of conductive layers are separated from one another by a first pitch, and the second plurality of conductive layers are separated from one another by a second pitch.

Example 40 includes the integrated circuit of Example 39, wherein the first pitch is substantially the same as the second pitch.

Example 41 includes the integrated circuit of Example 39 or 40, wherein the first pitch is edge-aligned along the first boundary of the standard unit cell, and the second pitch is edge-aligned along the second boundary of the standard unit cell.

Example 42 includes the integrated circuit of any one of Examples 29-41, wherein the first plurality of conductive layers extend along lengthwise along the first direction and the second plurality of conductive layers extend lengthwise along the first direction.

Example 43 is a die that includes the integrated circuit of any one of Examples 29-42.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor region extending from a first source or drain region to a second source or drain region in a first direction;
a second semiconductor region extending from a third source or drain region to a fourth source or drain region in the first direction;
a gate structure extending over the first semiconductor region and the second semiconductor region in a second direction;
wherein the first source or drain region is above and spaced from the third source or drain region in a third direction , and the second source or drain region is above and spaced from the fourth source or drain region in the third direction;
a first plurality of conductive layers above the first semiconductor region and extending lengthwise along the first direction, the first plurality of conductive layers being separated from one another along the second direction by a first pitch; and
a second plurality of conductive layers below the second semiconductor region and extending lengthwise along the first direction, the second plurality of conductive layers being separated from one another along the second direction by a second pitch;
wherein the first plurality of conductive layers are offset from the second plurality of conductive layers along the second direction by between 1 nm and 5 nm.

2. The integrated circuit of claim 1, wherein the first and second source or drain regions are n-type source or drain regions and the third and fourth source or drain regions are p-type source or drain regions.

3. The integrated circuit of claim 2, wherein the first and second source or drain regions comprise silicon and phosphorous and the third and fourth source or drain regions comprise silicon, germanium, and boron.

4. The integrated circuit of any one of claims 1 through 3, wherein the first semiconductor region comprises one or more first semiconductor nanoribbons and the second semiconductor region comprises one or more second semiconductor nanoribbons.

5. The integrated circuit of claim 4, wherein the one or more first semiconductor nanoribbons and the one or more second semiconductor nanoribbons comprises germanium, silicon, or any combination thereof.

6. The integrated circuit of any one of claims 1 through 5, wherein a first conductive layer of the first plurality of conductive layers is aligned along a first boundary of a standard unit cell that includes the first semiconductor region and the second semiconductor region, and a second conductive layer of the second plurality of conductive layers is aligned along a second boundary of the standard unit cell, the second boundary being parallel to the first boundary.

7. The integrated circuit of claim 6, further comprising:
a topside contact on a top surface of the first source or drain region; and
a via extending in the third direction from the topside contact to the first conductive layer.

8. The integrated circuit of claim 6 or 7, further comprising:
a backside contact on a bottom surface of the third source or drain region; and
a via extending in the third direction from the backside contact to the second conductive layer.

9. The integrated circuit of any one of claims 1 through 8, further comprising a conductive contact on at least a portion of a top surface of the second source or drain region and extending in the third direction to contact at least a portion of a side surface of the fourth source or drain region.

10. The integrated circuit of any one of claims 1 through 9, further comprising: a first dielectric layer between the first source or drain and the third source or drain region along the third direction; and a second dielectric layer between the second source or drain and the fourth source or drain region along the third direction.

11. The integrated circuit of any one of claims 1 through 10, wherein the gate structure comprises a first portion around the first semiconductor region comprising a first conductive material and a second portion around the second semiconductor region comprising a second conductive material that is not present in the first portion of the gate structure.

12. The integrated circuit of any one of claims 1 through 11, wherein the first pitch is substantially the same as the second pitch.

13. The integrated circuit of any one of claims 1 through 12, wherein the first direction is substantially orthogonal to the second direction, and the third direction is substantially orthogonal to the first and second directions.

14. The integrated circuit of any one of claims 1 through 13, wherein the first pitch is edge-aligned along a first boundary of a standard unit cell that includes the first semiconductor region and the second semiconductor region, and the second pitch is edge-aligned along a second boundary of the standard unit cell, the second boundary being parallel to the first boundary.

15. A die comprising the integrated circuit of any one of claims 1 through 14.
